Europäisches Patentamt

European Patent Office

Office européen des brevets

(19)

(11) Veröffentlichungsnummer: **0 150 878**
**B1**

(12) **EUROPÄISCHE PATENTSCHRIFT**

(45) Veröffentlichungstag der Patentschrift: **12.09.90**

(21) Anmeldenummer: **85200054.6**

(22) Anmeldetag: **21.01.85**

(60) Teilanmeldung 88113029 eingereicht am 11.08.88.

(51) Int. Cl.⁵: **C 23 C 16/50,** C 23 C 14/34, G 01 L 1/22

(54) Verfahren zur Herstellung eines Dünnfilmmessstreifensystems.

(30) Priorität: **30.01.84 DE 3403042**
**28.01.84 DE 3402971**

(43) Veröffentlichungstag der Anmeldung:
**07.08.85 Patentblatt 85/32**

(45) Bekanntmachung des Hinweises auf die
Patenterteilung:
**12.09.90 Patentblatt 90/37**

(84) Benannte Vertragsstaaten:
**BE DE FR GB IT LU NL SE**

(56) Entgegenhaltungen:
EP-A-0 068 636    US-A-3 748 253
EP-A-0 087 665    US-A-4 422 063
FR-A-2 339 001

PATENTS ABSTRACTS OF JAPAN, Band 5, Nr.
109 (E-65)781r, 15. Juli 1981; & JP - A - 56 049
521 (YASUMITSU KAJIWARA) 06.05.1981
PATENTS ABSTRACTS OF JAPAN, Band 7, Nr.
13 (E-153)1158r, 19. Januar 1983; & JP - A - 57
172 741 (NIPPON DENSHIN DENWA KOSHA)
23.10.1982

(73) Patentinhaber: **Philips Patentverwaltung GmbH**
**Wendenstrasse 35 Postfach 10 51 49**
**D-2000 Hamburg 1 (DE)**
(84) **DE**

(73) Patentinhaber: **N.V. Philips'**
**Gloeilampenfabrieken**
**Groenewoudseweg 1**
**NL-5621 BA Eindhoven (NL)**
(84) **BE FR GB IT LU NL SE**

(72) Erfinder: **Bringmann, Udo**
**Schulstrasse 18**
**D-2083 Halstenbek (DE)**
Erfinder: **Drews, Klaus**
**Gärtnerstrasse 35**
**D-2083 Halstenbek (DE)**
Erfinder: **Schön, Detlef Gerd, Dr.**
**Ulmenweg 10**
**D-2083 Halstenbek (DE)**
Erfinder: **Dössel, Olaf Helmut, Dr.**
**Danziger Strasse 18**
**D-2086 Ellerau (DE)**
Erfinder: **Gerstenberg, Klaus Wolfgang, Dr.**
**Papemoorweg 2**
**D-2083 Halstenbek (DE)**
Erfinder: **Kürsten, Gerhard**
**Ostfalenweg 16**
**D-2000 Hamburg 61 (DE)**

Courier Press, Leamington Spa, England.

**EP  0 150 878  B1**

56 Entgegenhaltungen:

**IBM TECHNICAL DISCLOSURE BULLETIN, Band 26, Nr. 2, Juli 1983, Seite 588, New York, US; B.L. RATHBUN et al.: "Passivating coating" THIN SOLID FILMS, Band 55, Nr. 2, Dezember 1978, Seiten 253-259; J. TYCZKOWSKI et al.: "On the mechanism of electrical conduction in glow discharge polysilazane films"**

Erfinder: **Orlowski, Reiner Uwe, Dr. Rotdornweg 17 D-2085 Quickborn (DE)**

74 Vertreter: **Nehmzow-David, Fritzi-Maria et al Philips Patentverwaltung GmbH Wendenstrasse 35 Postfach 10 51 49 D-2000 Hamburg 1 (DE)**

## Beschreibung

Die Erfindung bezieht sich auf ein Verfahren zur Herstellung eines Dünnfilm-Dehnungsmeßstreifen-Systems mit einem elastisch verformbaren, flexiblen Substrat, auf dem eine elektrisch isolierende Schicht und auf dieser eine strukturierte Widerstandsschicht sowie eine elektrisch gut leitfähige Schicht mit einer Struktur für die elektrische Kontaktierung angebracht sind.

Für die Messung der physikalischen Größen Masse, Kraft, Drehmoment, Beschleunigung, Durchfluß, Druck und Differenzdruck werden vorzugsweise Meßaufnehmer mit elektrischem Ausgangssignal verwendet. Meßaufnehmer auf Basis von Dehnungsmeßstreifen enthalten ein elastisches Element (Substrat), das durch die Meßgröße verformt wird, sowie einen Widerstand, mit dessen Hilfe diese Verformung in ein elektrisches Signal umgewandelt wird. Ein solches elektrisches Signal kann anschließend verstärkt und über große Entfernungen übertragen werden. Es kann in Regelschleifen eingeführt, von Rechnern verarbeitet oder gespeichert werden und auch leicht auf Displays dargestellt werden. Der Widerstand (Widerstandsschicht) kann die Umwandlung der Verformung in ein elektrisches Signal über eine Änderung seines Widerstandswertes erreichen.

Als Material für die Widerstandsschicht werden Metallegierungen und Halbleiter verwendet. Zur Messung der geringen Meßwiderstandsänderung werden z.B. vier aus der Widerstandsschicht gebildete Widerstandsbahnen, im weiteren als Dehnungsmeßstreifen bezeichnet, zu einer symmetrischen Wheatstone-Brücke zusammengeschaltet.

Die Abweichung vom Brückengleichgewicht ist proportional zur elastischen Verformung der Dehnungsmeßstreifen.

Dünnschicht - Dehnungsmeßstreifen - Systeme sind in unterschiedlichen Ausführungsformen bekannt, wobei insbesondere die Eigenschaften der elektrisch isolierenden Schicht zwischen dem elastischen Element und der Widerstandsschicht von Bedeutung sind. Für die elektrisch isolierende Schicht sind verschiedenartige Materialien eingesetzt worden, die sich in der Praxis aber als mit gewissen Nachteilen behaftet erwiesen haben.

So ist aus DE-OS 27 41 055 ein Dünnschicht-Dehnungsmeßstreifen-System bekannt, bei dem anorganische Schichten aus Oxiden ($Al_2O_3$, MgO oder Forsterit $2MgO \cdot SiO_2$) mit Hilfe von HF-Kathodenzerstäubung, Elektronenstrahlverdampfung oder mit heizbaren Verdampfern hergestellt werden.

Aus DE-OS 30 41 756 sind Dünnschicht-Dehnungsmeßstreifen-Systeme bekannt, bei denen anorganische Schichten aus Siliciumoxid oder Siliciumnitrid mittels Plasma-Chemical Vapour Deposition angebracht werden.

Aus der europäischen Patentanmeldung 53 337 sind Dünnschicht-Dehnungsmeßstreifen-Systeme bekannt, bei denen die elektrisch isolierende Schicht aus Polyimiden, polyamidimiden oder Epoxy-modifizierten Polyimiden besteht, wobei die Schichtmaterialien als Lösung auf das Substrat aufgebracht, geschleudert und durch eine Temperbehandlung ausgehärtet werden.

Mit den bekannten elektrisch isolierenden Schichten sind unterschiedliche Nachteile verknüpft.

Aufgedampfte oder durch Kathodenzerstäubung aufgebrachte Schichten erreichen nur eine schlechte Kantenbedeckung. Dies führt auf Unterlagen mit mikroskopisch kleinen Unebenheiten zu Kurzschlüssen zwischen dem elastischen Substrat und der Widerstandsschicht.

Die anorganischen Materialien sind darüberhinaus relativ spröde und weisen schon bei kleinen Belastungen Haarrisse auf, die die Langzeitstabilität des Dehnungsmeßstreifens nachteilig beeinflussen. Bei größeren Belastungen kommt es zu Brüchen, die zu Unterbrechungen der Widerstandsbahnen führen.

Die organischen Schichten können zwar eine hohe maximale Dehnbarkeit aufweisen, zeigen aber schlechte Kriecheigenschaften, insbesondere bei höheren Temperaturen.

Der Erfindung liegt die Aufgabe zugrunde, das eingangs genannte Verfahren zur Herstellung eines Dünnfilm-Dehnungsmeßstreifen-Systems dahingehend zu verbessern, daß Dünnfilm-Dehnungsmeßstreifen-Systeme geschaffen werden können, deren elektrisch isolierende Schichten zu einer guten Kantenbedeckung führen, eine hohe maximale Dehnbarkeit aufweisen und gleichzeitig bis über 300°C stabil sind und die das Kriechen des Federmaterials (Substrat) kompensieren können.

Diese Aufgabe wird erfindungsgemäß dadurch gelöst, daß die elektrisch isolierende Schicht aus einem Si:O:C:H und/oder Si:N:C:H-Verbindungen enthaltenden plasmapolymerisierten Material einer Dicke im Bereich von 0,2 bis 20 µm durch Abscheidung aus der Gasphase gebildet wird, wonach auf der Polymerschicht die Widerstandsschicht angebracht und zur Bildung mindestens einer Widerstandsbahn strukturiert wird und auf der strukturierten Widerstandsschicht elektrische Dünnschichtanschlüsse ausgebildet werden.

Nach einer vorteilhaften Weiterbildung des erfindungsgemäßen Verfahrens wird die elektrisch isolierende Schicht derart gebildet, daß in eine Plasma-Chemical Vapour Deposition-Anlage (PCVD-Anlage) monomere Prozeßgase eingespeist werden, aus denen durch Hochfrequenz-Anregung der Gasphasenmoleküle die polymerisierten Si:O:C:H- und/oder Si:N:C:H-haltigen Verbindungen gebildet werden können, die auf dem in der PCVD-Anlage befindlichen Substrat abgeschieden werden.

Nach einer weiteren vorteilhaften Ausbildung des Verfahrens gemäß der Erfindung wird eine elektrisch isolierende Schicht aus plasmapolymerisierten Siliconen oder Stickstoff-analogen Siliconen abgeschieden, wobei nach einer weiteren Ausbildung des erfindungsgemäßen Verfahrens als monomeres Prozeßgas Hexamethyldisilazan eingespeist wird.

Nach vorteilhaften Weiterbildungen des Verfahrens gemäß der Erfindung wird die Widerstandsschicht durch Aufdampfen oder durch kathodische Hochfrequenzzerstäubung oder durch Plasma-Chemical Vapour Deposition angebracht, wobei vorteilhafterweise eine Widerstandsschicht aus einer Metallegierung, beispielsweise aus einer Chrom/Nickel-Legierung, oder aus einem dotierten Halbleitermaterial, wie beispielsweise aus mit Bor oder Phosphor dotiertem Silicium, angebracht wird.

Nach vorteilhaften Weiterbildungen des erfindungsgemäßen Verfahrens wird ein Substrat aus Stahl oder aus einer Kupfer/Beryllium-Legierung eingesetzt.

Die mit der Erfindung erzielbaren Vorteile bestehen insbesondere darin, daß die elektrisch isolierenden Schichten aus plasmapolymerisiertem Material eine gute Kantenbedeckung haben. Sie weisen eine gute Dehnbarkeit auf, sind bis über 300°C stabil, wasserabweisend und chemisch resistent. Sie haften gut auf allen Materialien, aus denen üblicherweise das elastische Substrat hergestellt wird; außerdem besteht auch eine gute Haftung zur darüberliegenden Widerstandsschicht. Die Schichten lassen sich in jeder beliebigen für den Anwendungszweck geeigneten Dicke zwischen 0,2 µm und 20 µm präparieren. Darüberhinaus eröffnet sich die Möglichkeit, durch gezielte Einstellung der Dicke und der Zusammensetzung der Schicht das Kriechen des Federmaterials (Substratmaterials) zu kompensieren.

Die erfindungsgemäß hergestellten elektrisch isolierenden Schichten weisen für ihren Anwendungszweck damit hervorragende Eigenschaften auf:

Die Wahrscheinlichkeit für einen Kurzschluß zum elastischen Substrat (Federkörper) ist sehr klein, was den Vorteil einer hohen Ausbeute bei der Fertigung der erfindungsgemäßen Dehnungsmeßstreifen-Systeme mit sich bringt. Die erfindungsgemäß hergestellten elektrisch isolierenden Schichten weisen auch eine sehr gute Dehnbarkeit auf. Typische in Druck- und Kraftmeßaufnehmern auftretende Dehnungen liegen bei $1 \times 10^{-3}$ m/m. In Zonen ungleichmäßiger Dehnung können leicht Dehnungsspitzen von $2 \times 10^{-3}$ m/m auftreten. Soll auch eine Überlast-Festigkeit gewährleistet sein, so müssen Dehnungen bis zu $4 \times 10^{-3}$ m/m ohne Schaden überstanden werden. Diesen Anforderungen genügen die vorliegenden Isolationsschichten. Die vorliegenden elektrisch isolierenden Schichten sind bis zu 300°C stabil. Dies ist ein besonders wichtiger Vorteil, denn zum einen treten bei der Herstellung der dehnungsempfindlichen Widerstandsschicht auf der elektrisch isolierenden Schicht hohe Prozeßtemperaturen auf, zum anderen erfordert die Einstellung der gewünschten Eigenschaften der Widerstandsschicht meist eine thermische Nachbehandlung, bei der Temperaturen bis 300°C typisch sind.

Die vorliegende elektrisch isolierende Schicht ist auch unempfindlich gegenüber einer hohen relativen Luftfeuchtigkeit.

Bei konventionellen Dehnungsmeßstreifen-Systemen, bei denen eine Widerstandsfolie auf einen Kunststoffträger aufgebracht ist, der auf einen elastischen Verformungsträger aufgeklebt wird, bestehen der Kleber und das Trägermaterial (Substrat) aus organischen Materialien, die bei einer hohen relativen Luftfeuchtigkeit quellen und so das Meßsignal des Meßaufnehmers verfälschen.

Die vorliegenden elektrisch isolierenden Schichten weisen vorzügliche Haftungseigenschaften sowohl zum elastischen Substrat als auch zur Widerstandsschicht auf.

Bei oxidischen Isolationsschichten besteht z.B. das Problem der schlechten Haftung und dieser Schwierigkeit muß durch Anbringen zusätzlicher Schichten, die als Haftvermittler dienen, begegnet werden, was für eine industrielle Fertigung einen zusätzlichen Prozeßschritt und damit erhöhte Kosten bedeutet.

Die vorliegenden elektrisch isolierenden Schichten zeigen auch eine besonders gute chemische Resistenz gegenüber aggressiven Flüssigkeiten und Gasen. Dies ist von Vorteil bei der Betrachtung der Zuverlässigkeit und der Langzeitstabilität des Meßaufnehmers. In keinem Fall darf die elektrisch isolierende Schicht durch die Chemikalien angegriffen werden, die bei den notwendigen photolithographischen Strukturierungsprozessen eingesetzt werden. Ein weiterer Vorteil der vorliegenden elektrisch isolierenden Schichten ist, daß sie sehr dünn (ungefähr 0,2 µm bis 20 µm Dicke) hergestellt werden können, dabei aber weitgehend pinhole-frei, also dicht sind. Abgesehen von der Erhöhung der Prozeßkosten, die beim Aufbringen dicker Schichten in Dünnfilmtechnologie auftreten, ist eine gute thermische Kopplung zwischen dem elastischen Substrat und der Widerstandsschicht wichtig.

Auch ist für eine optimale Übertragung des Dehnungsprofils des elastischen Substrates auf die aus der Widerstandsschicht gebildeten Dehnungsmeßstreifen eine unmittelbare Verbindung wünschenswert.

Ein weiterer Vorteil ist, daß die vorliegenden elektrisch isolierenden Schichten in ihren Kriecheigenschaften gezielt einstellbar sind. Die langsame Verformung des elastischen Substrates (Federkörper) bei einer konstanten Belastung wird als Kriechen bezeichnet. Bei guten Federmaterialien verändert sich so die Dehnung an der Oberfläche innerhalb von 5 min nach einer Veränderung der Belastung um Werte zwischen 0,01% und 0,05% und verursacht auf diese Weise einen Fehler bei der Druck- bzw. Kraft-Messung. Bei geklebten Dehnungsmeßstreifen-Systemen gelingt es, durch besonders sorgfältige Vorgehensweise beim Kleben dieses Kriechen zu kompensieren, denn bei auf diese Weise hergestellten Meßaufnehmern ermüdet der Kleber ebenfalls und erzeugt so ein gegenläufiges Kriechen.

Mit Dünnfilm-Dehnungsmeßstreifen-Systemen ist nach derzeit herrschender Meinung eine derartige Kompensation des Kriechens des elastischen Substrates (Federkörper) nicht möglich (vergleiche W. Ort, Wägen und Dosieren, 1979, Nr. 3, Seite 86). Es hat sich nun aber überraschenderweise gezeigt, daß es mit den gemäß der Erfindung hergestellten Dünnfilm-Dehnungsmeßstreifen-Systemen im Gegensatz zur herrschenden Lehre möglich ist, das Kriechen des Materials des elastischen Substrates zu kompensieren. Unterschiedliche Materialien für das elastische Substrat weisen sowohl im Endwert nach 5 min als auch im zeitlichen Verlauf des Kriechens unterschiedliche Werte auf. Durch gezielte Einstellung der Dicke und der Präparationsparameter läßt sich das gegenläufige Kriechverhalten der elektrisch isolierenden Schicht weitgehend einstellen, so daß auf typischen Materialien für das elastische Substrat, z.B. Stahl, der Kriechfehler des Dehnungsmeßstreifen-Systems unter 0,01% bleibt.

Hierzu wird auf die Daten des Ausführungsbeispiels verwiesen.

Anhand der Zeichnung wird ein Ausführungsbeispiel der Erfindung beschrieben und in seiner Wirkungsweise erläutert. Es zeigen:

Fig. 1 einen schematischen Querschnitt durch ein nach dem Verfahren gemäß der Erfindung hergestelltes Dünnfilm-Dehnungsmeßstreifen-System;

Fig. 2 Schema einer HF-Diodenanlage für die Herstellung einer elektrisch isolierenden Schicht gemäß dem Verfahren nach der Erfindung.

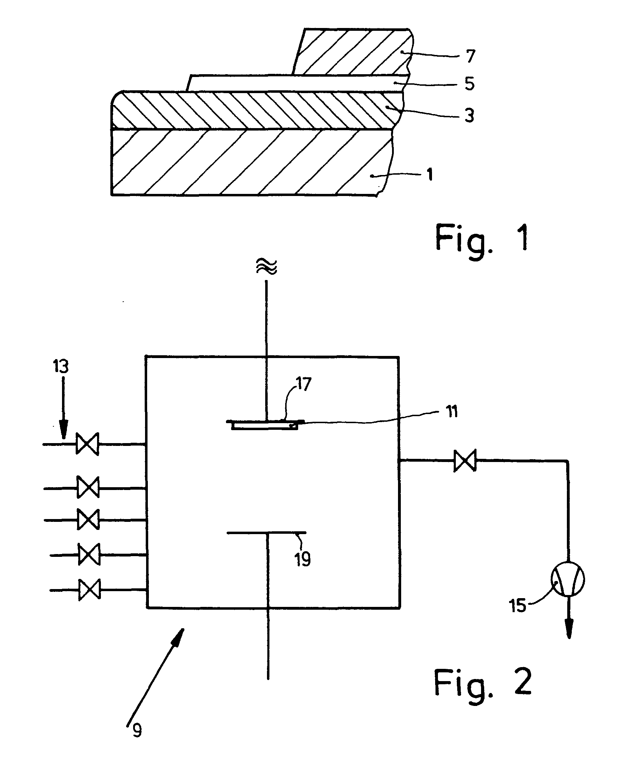

In Figur 1 ist schematisch der Schichtaufbau eines Dünnfilm-Dehnungsmeßstreifen-Systems dargestellt. Auf einem elastisch verformbaren, flexiblen Substrat 1, z.B. aus Stahl, wird eine etwa 3 µm dicke Schicht aus plasmapolymerisiertem Material als elektrisch isolierende Schicht 3 angebracht und auf dieser eine etwa 0,3 µm dicke Widerstandsschicht 5, z.B. aus einer mittels Kathodenzerstäubung aufgebrachten Nickel-Chrom-Legierung. Anschließend wird eine etwa 1 µm dicke gut leitfähige Schicht 7, z.B. aus Gold, für die Herstellung von Kontaktflecken und internen Verbindungen durch z.B. Kathodenzerstäubung angebracht.

Als Prozeßgas für die Herstellung der plasmapolymerisierten elektrisch isolierenden Schicht 3 wurde Hexamethyldisilazan in eine Plasma-CVD-Anlage 9 (vergleiche Figur 2) eingespeist. In dem in der PCVD-Anlage 9 erzeugten Hochfrequenz-Plasma wird das eingespeiste Gas gespalten. Auf einem in der PCVD-Anlage 9 auf einer der Elektroden 17, 19 angeordneten Substrat 11 entstehen durch Polymerisationsreaktionen dreidimensional vernetzte Makromoleküle mit Si-N-Si-Bindungen oder mit Si-O-Si-Bindungen, wenn statt Hexamethyldisilazan ein entsprechend geeignetes anderes polymeres Prozeßgas eingesetzt wird.

Eine mit Hexamethyldisilazan als siliciumhaltigem Prozeßgas hergestellte Schicht wurde unter folgenden Prozeßbedingungen präpariert:

Die PCVD-Anlage 9 wurde zunächst mit einer Vakuumpumpe 15 bis zu einem Druck von einigen $10^{-4}$ Pa evakuiert. Über eine der Zuleitungen 13 wurde als Prozeßgas Hexamethyldisilazan bei einem Druck von 0,2 Pa eingespeist. Der Elektrodenabstand betrug 50 mm. Es wurde ein 27 MHz-HF-Generator eingesetzt. Das sich an der HF-Elektrode 17, auf der mindestens ein zu beschichtendes Substrat 11 angeordnet war, einstellende Potential betrug 250 V Gleichspannung. Nach 60 min Abscheidungsdauer wurde eine 3 µm dicke Polymerschicht 3 auf dem(den) Substrat(en) 11 erhalten.

Dieses Ausführungsbeispiel beschreibt die Anregung der Gasphasenmoleküle durch eine Hochfrequenz-Spannung. Außer der Anregung mittels der in Figur 2 dargestellten Diodenanordnung sind prinzipiell auch eine induktive oder eine kapazitive Anregung der Gasphasenmoleküle möglich.

Nach Abscheidung der elektrisch isolierenden Schicht 3 wird die Widerstandsschicht 5 aufgebracht. Als Materialien für diese Schicht eignen sich außer den bereits genannten Legierungen NiCr oder PtW auch CrSi oder dotierte Halbleiter. Für die genannten Ausführungsbeispiele wurde CrNi verwendet. Widerstandsschichten aus allen genannten Materialien sind sehr stabil und relativ hochohmig. Die Widerstandsschicht kann mit allen dem Fachmann wohl bekannten Verfahren der Dünnschichttechnologie angebracht werden. Nach diesem Ausführungsbeispiel wurde ein HF-Kathodenzerstäubungsprozeß eingesetzt.

Die auf der Widerstandsschicht 5 befindliche Schicht 7 aus elektrisch gut leitfähigem Material, z.B. Gold, für die Anschlußkontaktierug wird ebenfalls durch HF-Kathodenzerstäubung erzeugt.

In zwei photolithographischen Prozeßschritten werden die Kontaktflecken aus der Goldschicht 7 sowie eine Wheatstone-Brückenstruktur aus der Widerstandsschicht herausgearbeitet. Die erforderlichen Ätzschritte können naßchemisch oder durch Ionenbeschuß (backsputtern) ausgeführt werden.

Die elektrischen Anschlüsse der Widerstandsbrücke werden von 4 Golddrähten gebildet, die auf den aus der Schicht 7 aus Gold gebildeten Kontaktflecken mittels Thermokompression befestigt werden.

Der Temperaturkoeffizient des elektrischen Widerstandes ($TC_R$) der aus der Widerstandsschicht erhaltenen Dehnungsmeßstreifen hat normalerweise einen zu niedrigen, negativen Wert. Durch eine thermische Nachbehandlung (Temperung) bei etwa 300°C läßt er sich jedoch einstellen. In Abhängigkeit von der Dauer des Temperns werden die Widerstandswerte kleiner, der Wert für den Temperaturkoeffizienten des elektrischen Widerstandes $TC_R$ wird dagegen größer und sogar positiv. Durch Wahl einer geeigneten Temperzeit kann der Einfluß der Temperatur auf den Widerstand vernachlässigbar klein gehalten werden. Diese Maßnahmen sind dem Fachmann geläufig.

Als letzter Verfahrensschritt empfiehlt sich, auf dem Dehnungsmeßstreifen-System eine Passivierungsschicht anzubringen, die das elastische Verhalten des flexiblen Substrats nicht beeinträchtigen darf;

zweckmäßigerweise ist ihre Schichtdicke auf etwa 10 µm begrenzt.

Technische Daten von nach der Erfindung hergestellten Dünnfilm-Dehnungsmeßstreifen-Systemen:

Substrat: Edelstahl, poliert

Isolationsschicht: Polymerschicht, Schichtdicke 3 µm

Widerstandsschicht: NiCr, Schichtdicke 0,3 µm

Flächenwiderstand: 4 Ohm

Widerstand einer einzelnen Widerstandsbahn: 130 Ohm Temperaturkoeffizient einer einzelnen Widerstandsbahn: + 10 ppm/K

Verhältnis der relativen Widerstandsänderung zur Dehnung (Dehnungsempfindlichkeit): 2,2

Kriechen (Kriechfehler): < 0,01%

Widerstand der Isolationsschicht: > $10^{11}$ Ohm·cm

maximal zulässige Dehnung: 2 bis $10 \times 10^{-3}$ m/m

pinhole-Dichte: 2/cm²

Durchschlagsfeldstärke: 150 V/µm

## Patentansprüche

1. Verfahren zur Herstellung eines Dünnfilm-Dehnungsmeßstreifen-Systems mit einem elastisch verformbaren, flexiblen Substrat, auf dem eine elektrisch isolierende Schicht und auf dieser eine strukturierte Widerstandsschicht sowie eine elektrisch gut leitfähige Schicht mit einer Struktur für die elektrische Kontaktierung angebracht sind,

dadurch gekennzeichnet,

daß die elektrisch isolierende Schicht aus einem Si:O:C:H und/oder Si:N:C:H-Verbindungen enthaltenden plasmapolymerisierten Material einer Dicke im Bereich von 0,2 bis 20 µm durch Abscheidung aus der Gasphase gebildet wird, wonach auf der Polymerschicht die Widerstandsschicht angebracht und zur Bildung mindestens einer Widerstandsbahn strukturiert wird und auf der strukturierten Widerstandsschicht elektrische Dünnschichtanschlüsse ausgebildet werden.

2. Verfahren nach Anspruch 1,

dadurch gekennzeichnet,

daß die elektrisch isolierende Schicht derart gebildet wird, daß in eine Plasma-Chemical Vapour Deposition-Anlage (PCVD-Anlage) monomere Prozeßgase eingespeist werden, aus denen durch Hochfrequenz-Anregung der Gasphasenmoleküle die polymerisierten Si:0:C:H- und/oder Si:N:C:H-haltigen Verbindungen gebildet werden können, die auf dem in der PCVD-Anlage befindlichen Substrat abgeschieden werden.

3. Verfahren nach den Ansprüchen 1 und 2,

dadurch gekennzeichnet,

daß eine elektrisch isolierende Schicht aus plasmapolymerisierten Siliconen oder Stickstoff-analogen Siliconen abgeschieden wird.

4. Verfahren nach mindestens einem der Ansprüche 1 bis 3,

dadurch gekennzeichnet,

daß als monomeres Prozeßgas Hexamethyldisilazan eingespeist wird.

5. Verfahren nach mindestens einem der Ansprüche 1 bis 4,

dadurch gekennzeichnet,

daß die Widerstandsschicht durch Aufdampfen angebracht wird.

6. Verfahren nach mindestens einem der Ansprüche 1 bis 4,

dadurch gekennzeichnet,

daß die Widerstandsschicht durch kathodische Hochfrequenzzerstäubung angebracht wird.

7. Verfahren nach mindestens einem der Ansprüche 1 bis 4,

dadurch gekennzeichnet,

daß die Widerstandsschicht durch Plasma-Chemical Vapour Deposition angebracht wird.

8. Verfahren nach den Ansprüchen 5 bis 7,

dadurch gekennzeichnet,

daß eine Widerstandsschicht aus einer Metallegierung angebracht wird.

9. Verfahren nach Anspruch 8,

dadurch gekennzeichnet,

daß eine Widerstandsschicht aus einer Chrom/Nickel-Legierung angebracht wird.

10. Verfahren nach den Ansprüchen 5 bis 7,

dadurch gekennzeichnet,

daß eine Widerstandsschicht aus einem dotierten Halbleitermaterial angebracht wird.

11. Verfahren nach Anspruch 10,

dadurch gekennzeichnet,

daß eine Widerstandsschicht aus mit Bor oder Phosphor dotiertem Silicium angebracht wird.

12. Verfahren nach mindestens einem der Ansprüche 1 bis 11,

dadurch gekennzeichnet,

daß ein Substrat aus Stahl eingesetzt wird.

13. Verfahren nach mindestens einem der Ansprüche 1 bis 11,

dadurch gekennzeichnet,

daß ein Substrat aus einer Kupfer/Beryllium-Legierung eingesetzt wird.

## Revendications

1. Procédé de fabrication d'un système de jauges de contrainte en couche mince comportant un substrat flexible élastiquement déformable sur lequel sont appliquées une couche isolante électrique surmontée d'une couche résistive structurée, ainsi que d'une couche bonne conductrice électrique présentant une structure qui se prête à la mise en contact électrique, caractérisé en ce que la couche isolante électrique est formée d'une matière polymérisée au plasma, contenant des compositions Si:O:C:H et/ou Si:N:C:H d'une épaisseur comprise entre 0,2 et 20 µm, par dépôt à partir de la phase gazeuse, après quoi la couche résistive est appliquée sur la couche polymère et est structurée en vue de former au moins une piste résistive, et des connexions électriques en couche mince sont formées sur la couche résistive structurée.

2. Procédé suivant la revendication 1, caractérisé en ce qu'on forme la couche isolante électrique en introduisant, dans une installation de dépôt de vapeur plasma-chimique, des gaz de traitement monomères à partir desquels, par excitation à haute fréquence des molécules de la phase gazeuse, peuvent être formées les compositions polymérisées de Si:O:C:H et/ou de Si:N:C:H qui sont déposées sur le substrat présent dans l'installation de dépôt de vapeur plasma-chimique.

3. Procédé suivant les revendications 1 et 2, caractérisé en ce que la couche isolante électrique est déposée à partir de silicones polymérisées au plasma ou de silicones analogues à l'azote.

4. Procédé suivant l'une quelconque des revendications 1 à 3, caractérisé en ce que de l'hexaméthylsilazane est introduit en tant que gaz de traitement monomère.

5. Procédé suivant l'une quelconque des revendications 1 à 4, caractérisé en ce que la couche résistive est appliquée par vaporisation.

6. Procédé suivant l'une quelconque des revendications 1 à 4, caractérisé en ce que la couche résistive est appliquée par pulvérisation cathodique à haute fréquence.

7. Procédé suivant l'une quelconque des revendications 1 à 4, caractérisé en ce que la couche résistive est appliquée par dépôt de vapeur plasma-chimique.

8. Procédé suivant les revendications 5 à 7, caractérisé en ce qu'une couche résistive est appliquée au départ d'un alliage métallique.

9. Procédé suivant la revendication 8, caractérisé en ce qu'une couche résistive est appliquée au départ d'un alliage de chrome-nickel.

10. Procédé suivant les revendications 5 à 7, caractérisé en ce qu'une couche résistive est appliquée au départ d'une matière semi-conductrice dopée.

11. Procédé suivant la revendication 10, caractérisé en ce qu'une couche résistive est appliquée au départ de silicium dopé au bore ou au phosphore.

12. Procédé suivant l'une quelconque des revendications 1 à 11, caractérisé en ce qu'un substrat en acier est utilisé.

13. Procédé suivant l'une quelconque des revendications 1 à 11, caractérisé en ce qu'un substrat en un cuprobéryllium est utilisé.

**Claims**

1. A method of manufacturing a thin-film strain gauge system having an elastically deformable flexible substrate which is coated with an electrically insulating layer on which a structured resistive film as well as an electrically readily conducting film having a structure for establishing the electric contact are provided, characterized in that the electrically insulating layer is formed from a Si:O:C:H and/or Si:N:C:H compounds containing plasma-polymerized material having a thickness in the range from 0.2 to 20μm by deposition from the gas phase, after which the resistive film is provided on the polymer layer and is structured to form at least a resistive track and electric thin-film connections are formed on the structured resistive film.

2. A method as claimed in Claim 1, characterized in that the electrically insulating layer is formed so that in a plasma chemical vapour deposition device (PCVD device) monomeric process gases are introduced from which by high frequency excitation of the gas phase molecules polymerized Si:O:C:H and/or Si:N:C:H-containing compounds can be formed which are deposited on the substrate present in the PCVD device.

3. A method as claimed in Claims 1 and 2, characterized in that an electrically insulating layer of plasma-polymerized silicones or nitrogen-analogous silicones is deposited.

4. A method as claimed in at least one of the Claims 1 up to and including 3, characterized in that hexamethyldisilizane is introduced as the monomeric process gas.

5. A method as claimed in at least one of the Claims 1 up to and including 4, characterized in that the resistive film is provided by vacuum evaporation.

6. A method as claimed in at least one of the Claims 1 up to and including 4, characterized in that the resistive film is provided by cathodic high-frequency sputtering.

7. A method as claimed in at least one of the Claims 1 up to and including 4, characterized in that the resistive film is provided by plasma chemical vapour deposition.

8. A method as claimed in Claims 5 up to and including 7, characterized in that a resistive film consisting of a metal alloy is provided.

9. A method as claimed in Claim 8, characterized in that a resistive film is provided which consists of a chromium/nickel alloy.

10. A method as claimed in Claims 5 up to and including 7, characterized in that a resistive film is provided which consists of a doped semiconductor material.

11. A method as claimed in Claim 10, characterized in that a resistive film is provided which consists of silicon doped with boron or phosphorus.

12. A method as claimed in at least one of the Claims 1 up to and including 11, characterized in that a substrate of steel is used.

13. A method as claimed in at least one of the Claims 1 up to and including 11, characterized in that a substrate of a copper/beryllium alloy is used.

Fig. 1

Fig. 2